# EUROPEAN PATENT SPECIFICATION

(11) **EP 0 551 697 B1**
(45) Date of publication and mention of the grant of the patent: **14.05.1997**
(21) Application number: 92300385.9
(22) Date of filing: 16.01.1992
(51) Int. Cl.: G03F 7/029

(54) **Photoinitiator system and photopolymerizable composition using the same**
Photoinitiatorsystem und eine dieses enthaltende photopolymerisierbare Zusammensetzung
Système photoinitiateur et composition photopolymérisable utilisant ce système

(43) Date of publication of application: 21.07.1993
(73) Proprietor: HITACHI CHEMICAL CO., LTD., Shinjuku-ku, Tokyo (JP)
(72) Inventor: Kaneko, Futami, Hitachi-shi (JP); Kaji, Makoto, Hitachi-shi (JP)
(74) Representative: Cresswell, Thomas Anthony

(56) References cited:
- EP-A- 0 295 044
- EP-A- 0 401 166

## Description

### BACKGROUND OF THE INVENTION

This invention relates to a photoinitiator system and a photopolymerizable composition using the system.

Photopolymerizable compositions are widely used for forming letterpresses, relief images, photoresists, etc. using a UV light source, etc. Recently, to have higher sensitivity is desired. Particularly, in the case of using photopolymerizable compositions in a scanning light exposure method, it is necessary to have sufficiently high sensitivity to visible light of 458, 488, and 514.5 nm derived from argon ion laser which is the most effective light source. In this field, various photoinitiator systems have been studied in order to increase the sensitivity. As the photoinitiators, there have been known benzoin and derivatives thereof, substituted or non-substituted polynuclear quinones, etc. But there have not been known any photoinitiators having sufficient sensitivity particularly to visible light.

### SUMMARY OF THE INVENTION

It is an object of the present invention to provide a photoinitiator system and a photopolymerizable composition including such a photoinitiator system which has high sensitivity to visible light.

The present invention provides a photo-initiator system comprising
(a) an aminobenzylidenecarbonyl compound of the formula: 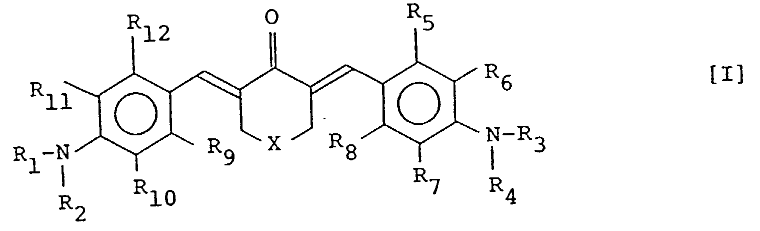 wherein R₁, R₂, R₃, and R₄ are the same or different and each is alkyl having 1 to 6 carbon atoms; R₅, R₆, R₇, R₈, R₉, R₁₀, R₁₁ and R₁₂ are the same or different and each is hydrogen, chlorine, bromine, alkyl having 1 to 12 carbon atoms, aryl or alkoxy having 1 to 12 carbon atoms; and X is oxygen, sulfur, or 〉NR in which R is hydrogen or alkyl having 1 to 12 carbon atoms, aralkyl having 7 to 20 carbon atoms, or aryl,
(b) an N-aryl-α-amino acid selected from;
   (i) an N-aryl-α-amino acid of the formula: 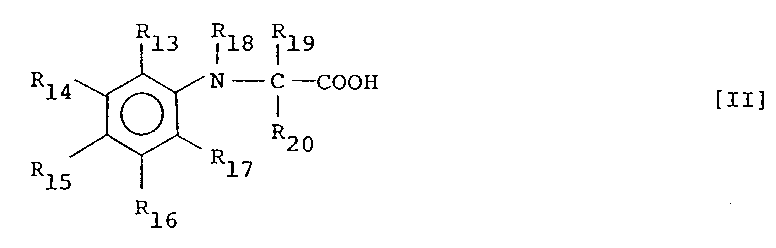 wherein R₁₃, R₁₄, R₁₅, R₁₆ and R₁₇ are the same or different and each is hydrogen, alkyl having 1 to 12 carbon atoms, or halogen; R₁₈ is alkyl having 1 to 12 carbon atoms, cycloalkyl, hydroxyalkyl having 1 to 12 carbon atoms, alkoxyalkyl having 2 to 12 atoms, aminoalkyl having 1 to 12 carbon atoms or aryl; and R₁₉ and R₂₀ are independently hydrogen or alkyl having 1 to 8 carbon atoms,
   (ii) N-(p-cyanophenyl) glycine,
   (iii) N-(p-chlorophenyl) glycine, and
   (iv) N-(p-cyanophenyl)-N-methyl glycine,
   and
   (c) a titanocene compound of the formula: 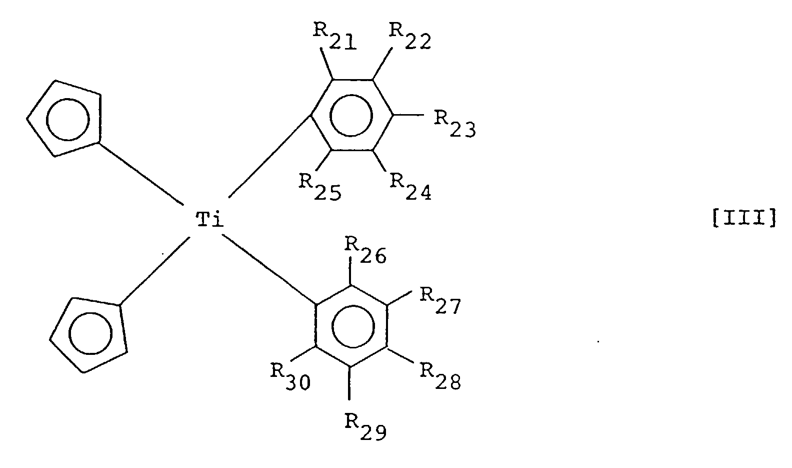 wherein R₂₁, R₂₂, R₂₃, R₂₄, R₂₅, R₂₆, R₂₇, R₂₈, R₂₉ and R₃₀ are the same or different and each is hydrogen, halogen, alkoxy having 1 to 20 carbon atoms, or a heterocyclic group.

The present invention also provides a photopolymerizable composition comprising (i) an addition polymerizable compound having a boiling point of 100°C or higher under normal pressure (1 atmosphere) and (ii) the photoinitiator system as mentioned above.

### DESCRIPTION OF THE PREFERRED EMBODIMENTS

The photoinitiator system of the present invention comprises (a) an aminobenzylidenecarbonyl compound of the formula [I], (b) an N-aryl-α-amino acid of the formula [II], and (c) a titanocene compound of the formula [III].

The aminobenzylidenecarbonyl compound is represented by the formula: 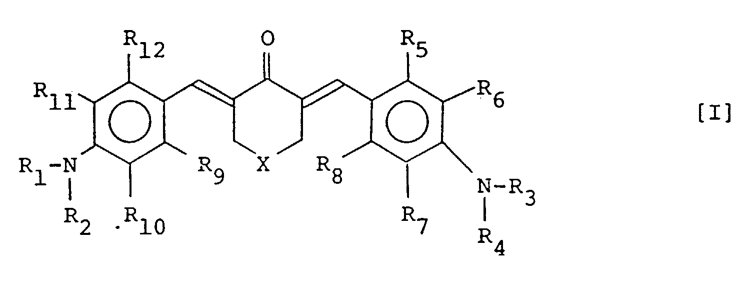 wherein R₁, R₂, R₃ and R₄ are the same or different and each is alkyl having 1 to 6 carbon atoms; R₅, R₆, R₇, R₈, R₉, R₁₀, R₁₁ and R₁₂ are the same or different and each is hydrogen, chlorine, bromine, alkyl having 1 to 12 carbon atoms, aryl group such as phenyl, naphthyl, tolyl or biphenyl, or alkoxy having 1 to 12 carbon atoms; and X is oxygen, sulfur or 〉NR in which R is hydrogen or alkyl group having 1 to 12 carbon atoms, aralkyl having 7 to 20 carbon atoms such as benzyl or phenylethyl, or aryl such as those mentioned above.

Concrete examples of the compound of formula [I] include the following:
2,6-bis(p-N,N-diethylaminobenzylidene)-4-methyl-4-azacyclohexanone,
2,6-bis(p-N,N-diethylaminobenzylidene)-4-ethoxycarbonyl-4-azacyclohexanone,
2,6-bis(p-N,N-diethylaminobenzylidene)-4-benzoyl-4-azacyclohexanone,
2,6-bis(p-N,N-diethylaminobenzylidene)-4-ethyl-4-azacyclohexanone,
2,6-bis(p-N,N-diethylaminobenzylidene)-4-phenetyl-4-azacyclohexanone,
2,6-bis(p-N,N-diethylaminobenzylidene)-4-benzyl-4-azacyclohexanone,
2,6-bis(p-N,N-diethylaminobenzylidene)-4-acetyl-4-azacyclohexanone,
2,6-bis(o-chloro-p-N,N-diethylaminobenzylidene)-4-methyl-4-azacyclohexanone,
2,6-bis(p-N,N-diethylaminobenzylidene)-4-oxocyclohexanone and
2,6-bis(p-N,N-diethylaminobenzylidene)-4-phenyl-4-azacyclohexanone.

The N-aryl-α-amino acid is selected from:
(i) N-aryl-α-amino acids represented by the formula: 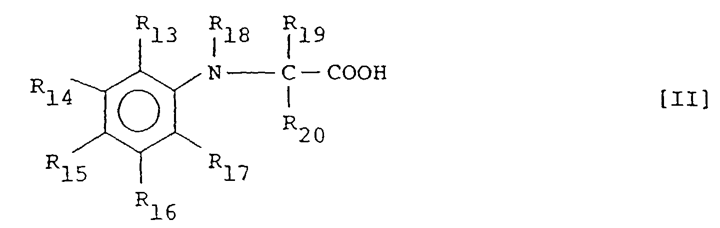 wherein R₁₃, R₁₄, R₁₅, R₁₆ and R₁₇ are the same or different and each is hydrogen, alkyl having 1 to 12 carbon atoms or halogen; R₁₈ is alkyl having 1 to 12 carbon atoms, cycloalkyl preferably having 3 to 10 carbon atoms, hydroxyalkyl having- 1 to 12 carbon atoms, alkoxyalkyl having 2 to 12 carbon atoms, aminoalkyl having 1 to 12 carbon atoms or aryl such as phenyl, naphthyl, tolyl or biphenyl; and R₁₉ and R₂₀ are the same or different and each is independently a hydrogen or alkyl having 1 to 8 carbon atoms,
(ii) N-(p-cyanophenyl) glycine,
(iii) N-(p-chlorophenyl) glycine, and
(iv) N-(p-cyanophenyl)-N-methyl glycine.

Concrete examples of the compound of formula [II] include the following:
N-(p-chlorophenyl)-N-ethyl glycine,
N-methyl-N-phenyl glycine,
N-(p-chlorophenyl)-N-methyl glycine,
N-(p-bromophenyl)-N-methyl glycine,
N-(p-chlorophenyl)-N-propyl glycine.

The titanocene compound is represented by the formula: 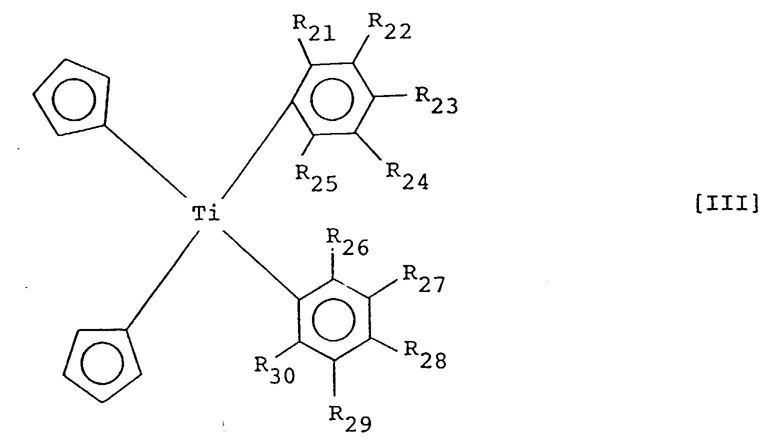 wherein R₂₁ through R₃₀ are the same or different and each is hydrogen, halogen, alkoxy having 1 to 20 carbon atoms, or a heterocyclic ring such as 1-pyrrolyl, 2-furyl or 2-thienyl.

Concrete examples of the compound of formula [III] include the following:
bis(cyclopentadienyl)-bis-[2,6-difluoro-3-(pyrrole-1-yl)-phenyl] titanium,
bis(cyclopentadienyl)-bis-(2,6-diflurorophenyl) titanium,
bis(cyclopentadienyl)-bis[(pyrrole-l-yl)-phenyl] titanium,
bis(cyclopentadienyl)-bis[2,6-dibromo-3-(pyrrole-1-yl)-phenyl] titanium and
bis(cyclopentadienyl)-bis-(2,6-dibromophenyl) titanium.

The addition polymerizable compound included in the photopolymerizable composition should have a boiling point of 100°C or higher under normal pressure (1 atmosphere). When the boiling point is lower than 100°C under normal pressure, the addition polymerizable compound is also flied off at the time of removing the solvent contained in the system by drying or at the time of irradiating with actinic light. Such flying off of the addition polymerizable compound is not preferable from the viewpoint of workability. Further, in order to obtain a uniform composition together with the photoinitiator system, the use of addition polymerizable compounds soluble in organic solvents is preferable.

As the organic solvent, there can be used acetone, methyl ethyl ketone, toluene, chloroform, methanol, ethanol, l,l,l-trichloroethane, etc.

As the addition polymerizable compound having a boiling point of 100°C or higher under normal pressure, there can be used the following compounds: Condensates of polyhydric alcohols and α,β-unsaturated carboxylic acids such as :
diethylene glycol di(meth)acrylate (including diacrylate or dimethacrylate, hereinafter used in the same manner),
triethylene glycol di(meth)acrylate,
tetraethylene glycol di(meth)acrylate,
trimethylolpropane di(meth)acrylate,
trimethylolpropane tri(meth)acrylate,
1,3-propanediol di(meth)acrylate,
1,3-butanediol (meth)acrylate,
pentaerythritol tetra(meth)acrylate,
dipentaerythritol hexa(meth)acrylate,
dipentaerythritol penta(meth)acrylate,
2,2-bis(4-acryloxydiethoxyphenyl)propane and
2,2-bis(4-methacryloxypentaethoxyphenyl)propane.
Adducts of glycidyl group-containing compounds with α,β-unsaturated carboxylic acids such as:

trimethylolpropane triglycidyl ether tri(meth)acrylate,
bisphenol A diglycidyl ether di(meth)acrylate
and a mixture of 2,2-bis(4-methacryloxypolyethoxyphenyl)propane (BPE-500, a trade name, mfd. by Shin-Nakamura Kagaku K.K.).
Unsaturated amides such as:
methylenebisacrylamide,
ethylenebisacrylamide and
1,6-hexamethylenebisacrylamide.
Vinyl esters such as:
divinyl succinate,
divinyl adipate,
divinyl phthalate,
divinyl terephthalate and
divinylbenzene-1,3-disulfonate.

These addition polymerizable compounds can be used alone or as a mixture thereof.

In the present invention, it is preferable to use 100 parts by weight of the addition polymerizable compound having a boiling point of 100°C or higher under normal pressure (in the case of using a high-molecular-weight organic polymer, 100 parts by weight of a total of the addition polymerizable compound and the high-molecular-weight organic polymer), 0.01 to 10 parts by weight of the aminobenzylidenecarbonyl compound of the formula [I], 0.05 to 20 parts by weight of the N-aryl-α-amino acid of the formula [II], and 0.05 to 20 parts by weight of the titanocene compound of the formula [III].

The photopolymerizable composition of the present invention may further comprise, if necessary, (iii) one or more high-molecular-weight organic polymers. As the high-molecular-weight organic polymer, there can be used thermoplastic polymers preferably having a molecular weight of 10,000 to 700,000.

Examples of such thermoplastic polymers are as follows:
(A) Copolyesters
   Copolyesters obtained from polyhydric alcohols such as diethylene glycol, triethylene glycol, tetraethylene glycol, trimethylolpropane, neopentyl glycol, etc. and polyvalent carboxylic acids such as tetraphthalic acid, isophthalic acid, sebacic acid and adipic acid.
(B) Vinyl polymers
   Homopolymers or copolymers of vinyl monomers such as methacrylic acid, acrylic acid; alkyl esters of acrylic or methacrylic acid such as methyl (meth)acrylate, ethyl (meth)acrylate, butyl (meth)acrylate, β-hydroxyethyl (meth)acrylate; styrene, vinyltoluene, vinyl chloride and vinyl butyral.
(C) Polyformaldehydes
(D) Polyurethanes
(E) Polycarbonates
(F) Nylons or polyamides
(G) Cellulose esters such as:
   methyl cellulose and
   ethyl cellulose.

By the addition of the high-molecular-weight organic polymer to the photopolymerizable composition, properties such as adhesiveness to a substrate, chemical resistance and film-forming properties can be improved. The high-molecular-weight organic polymer can preferably be added to the photopolymerizable composition in an amount of 20 to 80% by weight based on the total weight of the high-molecular-weight organic polymer and the addition polymerizable compound from the viewpoint of photo curability.

The photopolymerizable composition may further contain one or more colorants such as dyes and pigments. Examples of the colorants include fuchsin, Crystal Violet, Methyl Orange, Nile blue 2B, Victoria Pure Blue, Malachite Green, Night Green B and Spiron Blue.

The photopolymerizable composition may still further contain a radical polymerization inhibitor or a radical polymerization retarder in order to enhance stability during storage. Examples of such inhibitors or retarders include p-methoxyphenol, hydroquinone, pyrogallol, naphthylamine, phenothiazine and aryl phosphite.

The photopolymerizable composition may further contain one or more conventional additives such as plasticizers and adhesion enhancers.

The photopolymerizable composition can be used for producing a printing plate by coating the composition on a support such as polyethylene terephthalate film, drying it and laminating it on a substrate so as to make the composition contact with the substrate, followed by exposure to actinic light. The photopolymerizable composition can also be used as a photoresist for forming circuits by etching or plating.

The photopolymerizable composition can directly be coated on a substrate, followed by drying.

According to the present invention, a photopolymerizable element can be obtained by coating the photopolymerizable composition on a support, followed by drying.

Further, a resist image can be produced by laminating the photopolymerizable element mentioned above on a substrate so as to make the composition contact with the substrate, exposing the element to actinic light (from the side of the element), and developing the element in a conventional manner.

As the actinic light source, there can be used light sources which can emit actinic light of wavelengths of 300 to 600 nm. Examples of the light source include a carbon arc lamp, a mercury lamp, a xenon arc lamp, an argon glow lamp and an argon ion laser. In order to conduct direct imaging by scanning light exposure without using a mask, the use of argon ion laser is particularly preferable.

As the support, there can be used organic polymer films such as a polyethylene film, a polypropylene film and, a polyethylene terephthalate film. As the substrate, there can be used for instance metal plates (such as a copper plate, an aluminum plate and an iron plate) and copper-clad insulating boards (such as glass epoxy substrate, paper epoxy substrate and paper phenol substrate).

The photoinitiator system of the present invention gives high sensitivity to visible light. This seems to be that the aminobenzylidene compound of the formula [I] and the titanocene compound of the formula [III] absorb the light to generate an activated state, which is a good oxidant and causes a redox reaction with the N-aryl-α-amino acid of the formula [II] to generate effectively active radicals which initiate vinyl polymerization.

The present invention is illustrated by way of the following Examples, in which all parts and percents are by weight unless otherwise specified.

### Examples 1 and 2 and Comparative Examples 1 to 8

| Preparation of Photopolymerizable Compositions: | |
|---|---|
| 40% ethyl Cellosolve solution of acrylic copolymer [methacrylic acid/methyl methacrylate/butyl methacrylate/2-ethylhexyl acrylate = 23/51/6/20 (weight ratio), weight average molecular weight: about 90,000] | 120 parts |
| tetraethylene glycol diacrylate | 25 parts |
| hydroquinone | 0.04 part |
| photoinitiator system (shown in Table 1) methyl ethyl ketone | 20 parts |

The above-mentioned ingredients were stirred to make a uniform solution and coated on a polyethylene terephthalate film of 23 µm thick (Lumilar, a trade name, mfd. by Toray Industries, Inc.) using a bar coater. After drying at 90°C in a hot air convection type drier for about 3 minutes, there was obtained a photopolymerizable element. The thickness of the photopolymerizable composition layer after dried was 40 µm.

On the laminated sample of polyethylene terephthalate film, a Step Tablet (a trade name, Gray-Scale, mfd. by Dainippon Screen Mfg. Co., Ltd., optical density differences 0.15; minimum optical density 0.05; maximum optical density 3.05; negative film with 21 steps) was adhered, followed by light exposure using a laser direct imaging system mounting a 5W argon ion laser [mfd. by Nikon Corp., LP-3000D laser light (light intensity on the substrate surface about 180 mW, beam diameter 40 µm)]. Then, the polyethylene terephthalate film was peeled off, followed by washing off of uncured portions by spraying thereon a 1% aqueous solution of Na₂CO₃ at 30°C for 60 seconds. The step number of Step Tablets of retained cured film was read out to determine the sensitivity of the photopolymerizable composition (the larger the step number, the higher the sensitivity).

The results are shown in Table 1.

As mentioned above, by using the photoinitiator system of the present invention, there can be obtained the photopolymerizable composition having high sensitivity to visible light.

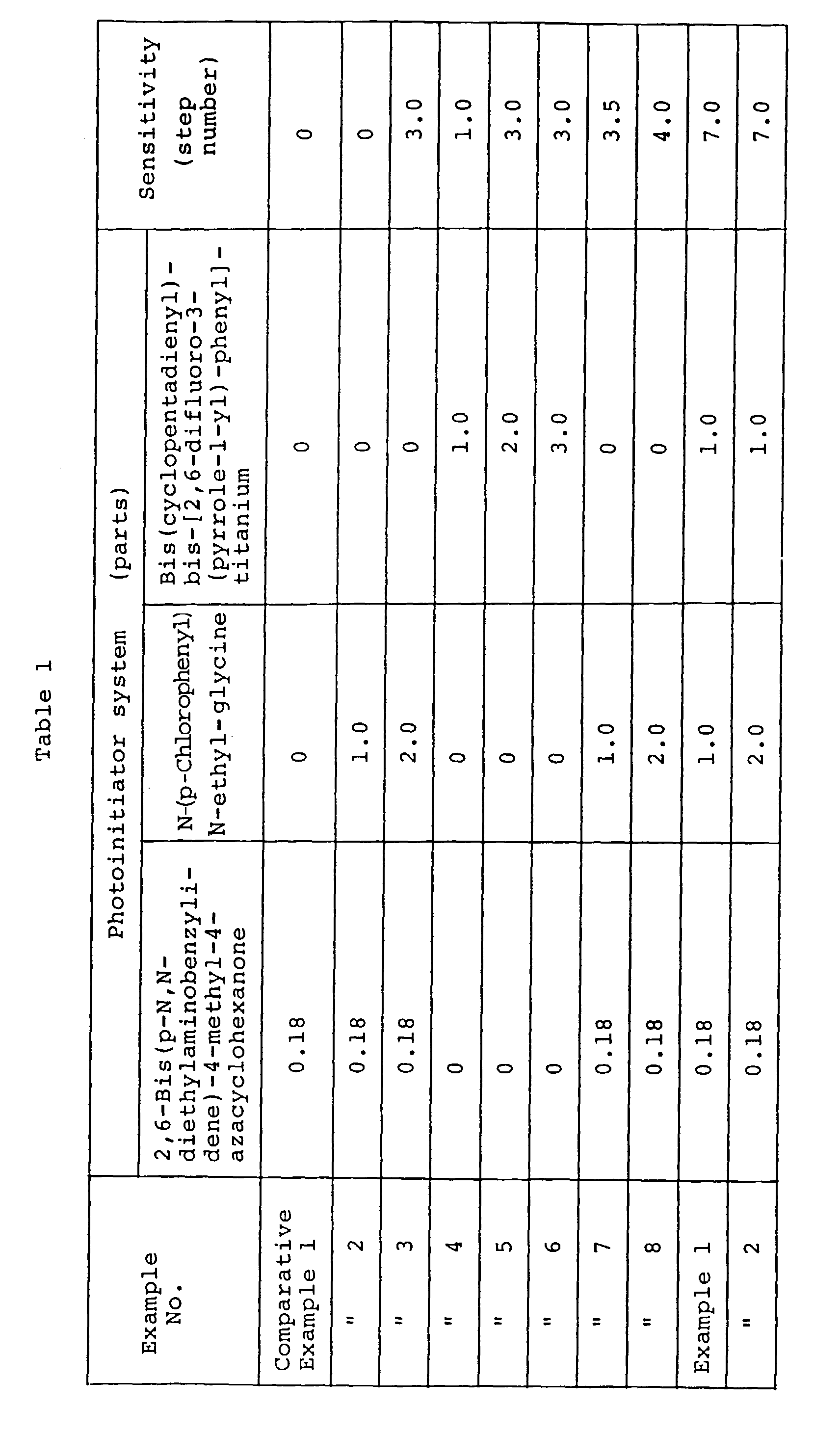

## Claims

1. A photoinitiator system comprising
(a) an aminobenzylidenencarbonyl compound of the formula: 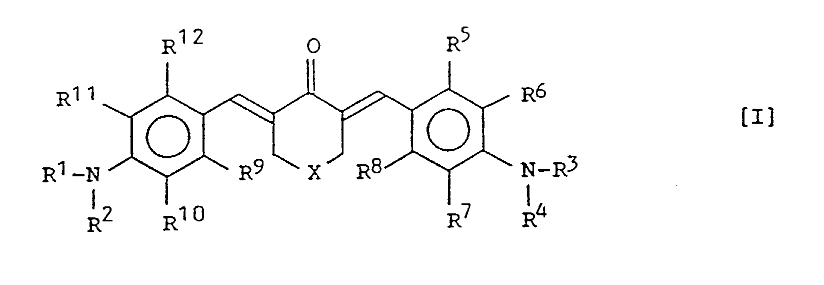 wherein R¹, R², R³ and R⁴ are the same or different and each is alkyl having 1 to 6 carbon atoms; R⁵, R⁶, R⁷, R⁸, R⁹, R¹⁰, R¹¹ and R¹² are the same or different and each is hydrogen, chlorine, bromine, alkyl having 1 to 12 carbon atoms, aryl or alkoxy having 1 to 12 carbon atoms; and X is oxygen, sulfur or >NR in which R is hydrogen or alkyl having 1 to 12 carbon atoms, aralkyl having 7 to 20 carbon atoms, or aryl,
(b) an N-aryl-α-amino acid selected from
(i) an N-aryl-α-amino acid of the formula: 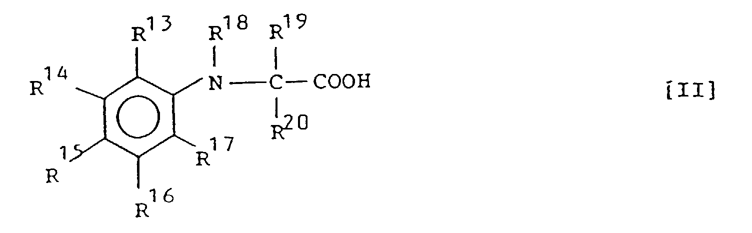 wherein R¹³, R¹⁴, R¹⁵, R¹⁶ and R¹⁷ are the same or different and each is hydrogen, alkyl having 1 to 12 carbon atoms or halogen; R¹⁸ is alkyl having 1 to 12 carbon atoms, cycloalkyl, hydroxyalkyl having 1 to 12 carbon atoms, alkoxyalkyl having 2 to 12 carbon atoms, aminoalkyl having 1 to 12 carbon atoms or aryl; and R¹⁹ and R²⁰ are independently hydrogen or alkyl having 1 to 8 carbon atoms,
(ii) N-(p-cyanophenyl) glycine,
(iii) N-(p-chlorophenyl) glycine and
(iv) N-(p-cyanophenyl)-N-methyl glycine, and
(c) a titanocene compound of the formula: 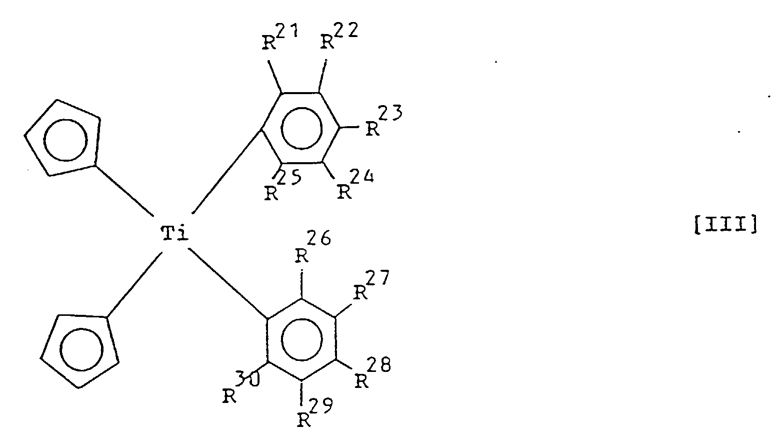 wherein R²¹, R²², R²³, R²⁴, R²⁵, R²⁶, R²⁷, R²⁸, R²⁹ and R³⁰ are the same or different and each is hydrogen, halogen, alkoxy having 1 to 20 carbon atoms, or a heterocyclic group.

2. A photoinitiator system according to claim 1 comprising 0.01 to 10 parts by weight of component (a), 0.05 to 20 parts by weight of component (b) and 0.05 to 20 parts by weight of component (c).

3. A photoinitiator system according to claim 1 or claim 2 wherein component (a) is 2,6-bis(p-N,N-diethylaminobenzylidene)-4-methyl-4-azacyclohexanone, component (b) is N-(p-chlorophenyl)-N-ethyl glycine, and component (c) is bis(cyclopentadienyl)-bis-[2,6-difluoro-3-(pyrrole-1-yl)phenyl] titanium.

4. A photopolymerizable composition comprising
(i) an addition polymerizable compound having a boiling point of 100°C or higher under normal pressure, and
(ii) a photoinitiator system according to any one of claims 1 to 3.

5. A composition according to claim 4 wherein the addition polymerizable component (i) is at least one compound selected from unsaturated amides; vinyl esters; condensates of polyhydric alcohols and α,β-unsaturated carboxylic acids; and adducts of glycidyl group-containing compounds with α,β-unsaturated carboxylic acids.

6. A composition according to claim 4, or claim 5 which further comprises
(iii) one or more high-molecular-weight organic polymers.

7. A composition according to claim 6 wherein the high-molecular-weight organic polymer is a copolyester, vinyl polymer, polyformaldehyde, polyurethane, polycarbonate, polyamide, nylon or a cellulose ester.

8. A photopolymerizable element obtained by coating a composition according to any one of claims 4 to 7 on a support, followed by drying.

9. A process for producing a resist image, which comprises laminating a photopolymerizable element according to claim 8 on a substrate so as to make the composition contact with the substrate, exposing to actinic light from the side of the support, and developing the element.

10. Use of an initiator system according to any one of claims 1 to 3 or of a composition according to any one of claims 4 to 7 or of a photopolymerisable element according to claim 8 in forming an image.

## Patentansprüche

1. Photoinitiatorsystem, umfassend
(a) eine Aminobenzylidencarbonylverbindung der Formel: 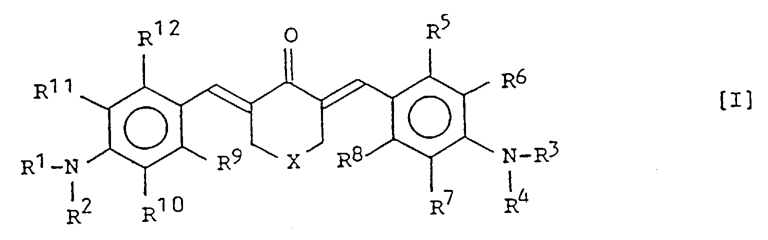 worin R¹, R², R³ und R⁴ gleich oder unterschiedlich sind und je Alkyl mit 1 bis 6 Kohlenstoffatomen bedeuten; R⁵, R⁶, R⁷, R⁸, R⁹, R¹⁰, R¹¹ und R¹² gleich oder unterschiedlich sind und je Wasserstoff, Chlor, Brom, Alkyl mit 1 bis 12 Kohlenstoffatomen, Aryl oder Alkoxy mit 1 bis 12 Kohlenstoffatomen bedeuten; und X Sauerstoff, Schwefel oder >NH bedeutet, worin R Wasserstoff oder Alkyl mit 1 bis 12 Kohlenstoffatomen, Aralkyl mit 7 bis 20 Kohlenstoffatomen oder Aryl bedeutet;
(b) eine N-Aryl-α-aminosäure, ausgewählt aus
(i) einer N-Aryl-α-aminosäure der Formel: 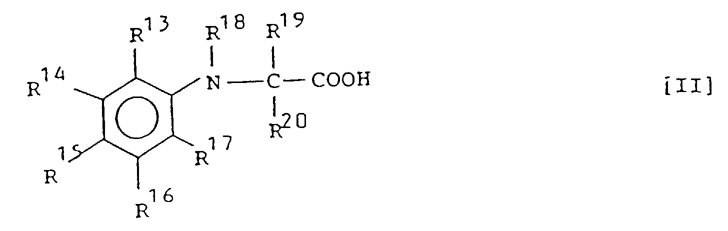 worin R¹³, R¹⁴, R¹⁵, R¹⁶ und R¹⁷ gleich oder unterschiedlich sind und je Wasserstoff, Alkyl mit 1 bis 12 Kohlenstoffatomen oder Halogen bedeuten; R¹⁸ Alkyl mit 1 bis 12 Kohlenstoffatomen, Cycloalkyl, Hydroxyalkyl mit 1 bis 12 Kohlenstoffatomen, Alkoxyalkyl mit 2 bis 12 Kohlenstoffatomen, Aminoalkyl mit 1 bis 12 Kohlenstoffatomen oder Aryl bedeutet; und R¹⁹ und R²⁰ unabhängig Wasserstoff oder Alkyl mit 1 bis 8 Kohlenstoffatomen bedeuten;
(ii) N-(p-Cyanophenyl)glycin,
(iii) N-(p-Chlorphenyl)glycin und
(iv) N-(p-Cyanophenyl)-N-methylglycin; und
(c) eine Titanocenverbindung der Formel: 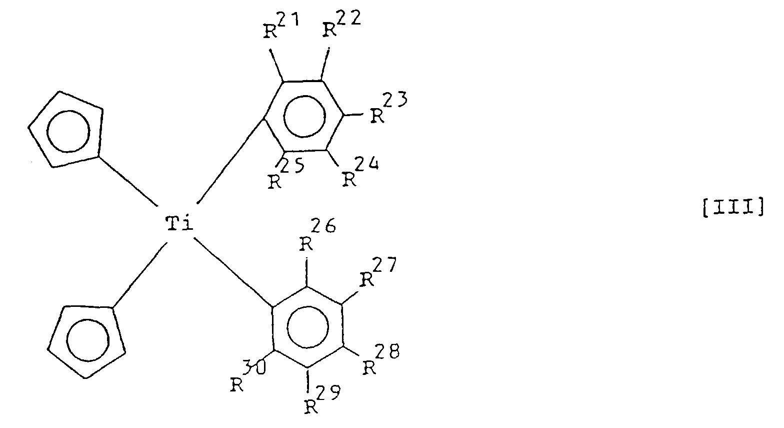 worin R²¹, R²², R²³, R²⁴, R²⁵, R²⁶, R²⁷, R²⁸, R²⁹ und R³⁰ gleich oder unterschiedlich sind und je Wasserstoff, Halogen, Alkoxy mit 1 bis 20 Kohlenstoffatomen oder eine heterocyclische Gruppe bedeuten.

2. Photoinitiatorsystem nach Anspruch 1, dadurch **ge-kennzeichnet,** daß es 0,01 bis 10 Gew.-Teile der Komponente (a), 0,05 bis 20 Gew.-Teile der Komponente (b) und 0,05 bis 20 Gew.-Teile der Komponente (c) enthält.

3. Photoinitiatorsystem nach Anspruch 1 oder Anspruch 2, dadurch **gekennzeichnet**, daß die Komponente (a) 2,6-Bis-(p-N,N-diethylaminobenzyliden)-4-methyl-4-aza-cyclohexanon, die Komponente (b) N-(p-Chlorphenyl)-N-ethylglycin und die Komponente (c) Bis(cyclopentadienyl)-bis-[2,6-difluor-3-(pyrrol-1-yl)phenyl]titanium ist.

4. Photopolymerisierbare Zusammensetzung, umfassend:
(i) eine additionspolymerisierbare Verbindung mit einem Siedepunkt von 100°C oder höher bei Normaldruck und
(ii) ein Photoinitiatorsystem nach einem der Ansprüche 1 bis 3.

5. Zusammensetzung nach Anspruch 4, dadurch **gekennzeichnet**, daß die additionspolymerisierbare Komponente (i) mindestens eine Verbindung, ausgewählt aus ungesättigten Amiden, Vinylestern, Kondensaten mehrwertiger Alkohole und α,β-ungesättigten Carbonsäuren und Addukten von Glycidylgruppen enthaltenden Verbindungen mit α,β-ungesättigten Carbonsäuren, ist.

6. Zusammensetzung nach Anspruch 4 oder Anspruch 5, dadurch **gekennzeichnet,** daß sie zusätzlich
(iii) ein oder mehrere organische Polymere mit hohem Molekulargewicht enthält.

7. Zusammensetzung nach Anspruch 6, dadurch **gekennzeichnet,** daß das organische Polymere mit hohem Molekulargewicht ein Copolyester, ein Vinylpolymeres, ein Polyformaldehyd, ein Polyurethan, ein Polycarbonat, ein Polyamid, Nylon oder ein Celluloseester ist.

8. Photopolymerisierbares Element, erhalten durch Beschichten eines Trägers mit einer Zusammensetzung nach einem der Ansprüche 4 bis 7 und anschließendes Trocknen.

9. Verfahren zur Herstellung eines Resistbildes, welches umfaßt: Laminieren eines photopolymeriserbaren Elements nach Anspruch 8 auf ein Substrat, so daß die Zusammensetzung in Kontakt mit dem Substrat ist, Belichten mit aktinischem Licht von der Seite des Trägers aus und Entwicklung des Elements.

10. Verwendung eines Initiatorsystem nach einem der Ansprüche 1 bis 3 oder einer Zusammensetzung nach einem der Ansprüche 4 bis 7 oder eines photopolymerisierbaren Elements nach Anspruch 8 zur Herstellung eines Bildes.

## Revendications

1. Système photoamorceur comprenant :
(a) un composé aminobenzylidènecarbonylé répondant à la formule : 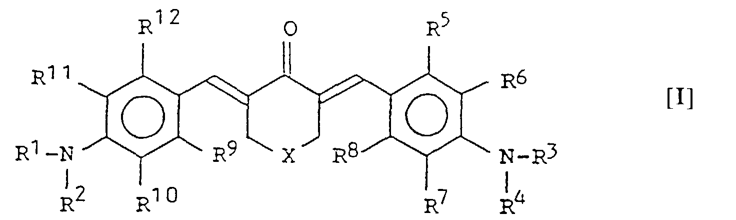 dans laquelle R¹, R², R³ et R⁴ sont identiques ou différents, et chacun représente un groupe alkyle comportant de 1 à 6 atomes de carbone ; R⁵, R⁶, R⁷, R⁸, R⁹, R¹⁰, R¹¹ et R¹² sont identiques ou différents et chacun représente un atome d'hydrogène, de chlore, de brome, un groupe alkyle comportant de 1 à 12 atomes de carbone, un groupe aryle ou alcoxy comportant de 1 à 12 atomes de carbone ; et X représente un atome d'oxygène, un atome de soufre ou >NR dans lequel R représente un atome d'hydrogène ou un groupe alkyle comportant de 1 à 12 atomes de carbone, un groupe aralkyle comportant de 7 à 20 atomes de carbone, ou un groupe aryle,
(b) un acide N-aryl-α-aminé choisi parmi
(i) un acide N-aryl-α-aminé répondant à la formule : 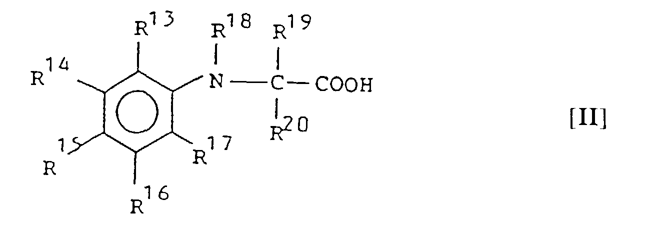 dans laquelle R¹³, R¹⁴, R¹⁵, R¹⁶ et R¹⁷ sont identiques ou différents et chacun représente un atome d'hydrogène, un groupe alkyle comportant de 1 à 12 atomes de carbone, ou un atome d'halogène ; R¹⁸ représente un groupe alkyle comportant de 1 à 12 atomes de carbone, un groupe cycloalkyle, hydroxyalkyle comportant de 1 à 12 atomes de carbone,un groupe alcoxyalkyle comportant de 2 à 12 atomes de carbone, un groupe aminoalkyle comportant de 1 à 12 atomes de carbone ou un groupe aryle ; et R¹⁹ et R²⁰ représentent indépendamment un atome d'hydrogène ou un groupe alkyle comportant de 1 à 8 atomes de carbone,
(ii) la N-(p-cyanophényl)glycine,
(iii) la N-(p-chlorophényl)glycine, et
(iv) la N-(p-cyanophényl)-N-méthylglycine, et
(c) un composé de type titanocène répondant à la formule : 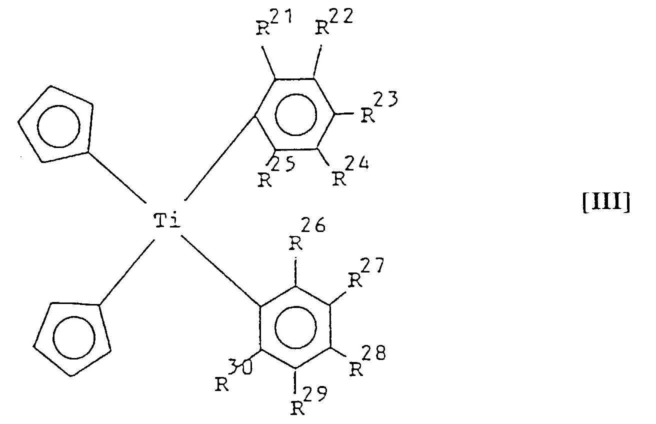 dans laquelle R²¹, R²², R²³, R²⁴, R²⁵, R²⁶, R²⁷, R²⁸, R²⁹ et R³⁰ sont identiques ou différents et chacun représente un atome d'hydrogène, un atome d'halogène, un groupe alcoxy comportant de 1 à 20 atomes de carbone, ou un groupe hétérocyclique.

2. Système photoamorceur conforme à la revendication 1, comprenant de 0,01 à 10 parties en poids de composant (a), de 0,05 à 20 parties en poids de composant (b) et de 0,05 à 20 parties en poids de composant (c).

3. Système photoamorceur conforme à la revendication 1 ou 2, dans lequel le composant (a) est la 2,6-bis(p-N,N-diéthylaminobenzylidène)-4-méthyl-4-azacyclohexanone, le composant (b) est la N-(p-chlorophényl)-N-éthylglycine, et le composant (c) est le bis(cyclopentadiényl)-bis[2,6-difluoro-3-(pyrrole-1-yl)-phényl] titane.

4. Composition photopolymérisable comprenant :
(i) un composé polymérisable d'addition présentant un point d'ébullition de 100° C ou supérieur sous une pression normale, et
(ii) un système photoamorceur conforme à l'une quelconque des revendications 1 à 3.

5. Composition conforme à la revendication 4, dans laquelle le composant polymérisable d'addition (i) est au moins un composé choisi parmi les amides insaturés, les esters vinyliques, les produits de condensation des alcools polyhydriques et des acides carboxyliques insaturés en α, β, et des produits d'addition de composés contenant un groupe glycidyle avec des acides carboxyliques insaturés en α,β.

6. Composition conforme à la revendication 4 ou 5, qui comprend en outre :
(iii) un ou plusieurs polymères organiques de masse moléculaire élevée.

7. Composition conforme à la revendication 6, dans laquelle le polymère organique à masse moléculaire élevée est un copolyester, un polymère vinylique, un polyformaldéhyde, un polyuréthanne, un polycarbonate, un polyamide, un nylon ou un ester de cellulose.

8. Element photopolymérisable obtenu par dépôt d'une composition conforme à l'une quelconque des revendications 4 à 7, sur un support, suivi par un séchage.

9. Procédé pour produire une image de résist, qui comprend la stratification d'un élément photopolymérisable conforme à la revendication 8, sur un substrat de manière à mettre la composition en contact avec le substrat, l'exposition à de la lumière actinique à partir d'une source située du côté du support, et le développement de l'élément.

10. Utilisation d'un système amorceur conforme à l'une quelconque des revendications 1 à 3, ou d'une composition conforme à l'une quelconque des revendications 4 à 7, ou d'un élément photopolymérisable conforme à la revendication 8, pour former une image.
